# EUROPÄISCHE PATENTSCHRIFT

(11) **EP 1 959 509 B1**
(45) Veröffentlichungstag und Bekanntmachung des Hinweises auf die Patenterteilung: **19.08.2009**
(21) Anmeldenummer: 08001328.7
(22) Anmeldetag: 24.01.2008
(51) Int. Cl.: H01L 39/24, F27B 9/04, B22F 3/00

(54) **Verfahren zum Herstellen eines HTSL-Bandes**
Method for manufacturing a high temperature superconductor tape
Procédé de fabrication d'une bande de matériau supraconducteur à température élevée

(30) Priorität: 15.02.2007 DE 102007007567
(43) Veröffentlichungstag der Anmeldung: 20.08.2008
(73) Patentinhaber: Zenergy Power GmbH, 53359 Rheinbach (DE)
(72) Erfinder: Bäcker, Michael, Dr., 50670 Köln (DE)
(74) Vertreter: Prietsch, Reiner

(56) Entgegenhaltungen:
- EP-A- 1 705 720
- US-A1- 2002 082 171
- US-A1- 2003 127 051
- US-A1- 2005 127 133

## Beschreibung

Die Erfindung betrifft ein Verfahren zum Herstellen eines Hochtemperatursupraleiters (HTSL) aus einem Band mit einer oberseitigen Precursorschicht, das zum kontinuierlichen Sintern letzterer in einem Ofen in Anwesenheit eines eingespeisten Reaktionsgases über einen Träger gezogen wird.

Ein solches Verfahren ist aus der WO 03/067672 A2 bekannt. Das Reaktionsgas wird von oben mittels Düsen in Richtung des Bandes gelenkt. Neben den Düsen wird verbrauchtes Reaktionsgas durch ein poröses Material hindurch großflächig abgesaugt. Bei dieser Art der Reaktionsgasführung mischt sich unkontrolliert frisches mit verbrauchtem Reaktionsgas, was zu Qualitätseinbußen der HTSL-Schicht führt und/oder lange Verweilzeiten des Bandes im Ofen erfordert.

Der Erfindung liegt die Aufgabe zugrunde, ein Verfahren der einleitend angegebenen Gattung so weiterzubilden, dass ein bandförmiger HTSL mit konstant hoher Qualität herstellbar ist. Weiter ist es Aufgabe der Erfindung einen Ofen zur Durchführung eines solchen Verfahrens bereitzustellen.

Diese Aufgaben sind durch ein Verfahren nach dem Anspruch 1 bzw. einen Ofen mit den Merkmalen des Anspruches 10 gelöst.

Erfindungsgemäß wird das Band über einen porösen Träger gezogen, in welchen das Reaktionsgas kontinuierlich eingespeist wird. Deshalb bildet sich über dem Träger und neben dem Band ein laminarer Strom des eingespeisten frischen Reaktionsgases. Über dem Band bildet sich im Strömungsschatten des Bandes eine Wirbelzone. Im Grenzbereich zwischen der Wirbelzone und den Bereichen laminarer Strömung seitlich der Wirbelzone findet ein ständiger Gasaustausch zwischen der Wirbelzone und der laminaren Strömung statt. Dadurch ist die Wirbelzone stets ausreichend mit frischem Reaktionsgas angereichert. Die Wirbel sorgen für eine gute Durchmischung von frischem und verbrauchtem Reaktionsgas. So ist sichergestellt, dass die Precursorschicht während des Sinterns gleichmäßig und ausreichend mit Reaktionsgas beströmt wird.

Weil ein Teil des in den Träger eingespeisten Reaktionsgases nicht im Austausch mit der Wirbelzone steht, wird das Reaktionsgas vorteilhafterweise in einem Kreislauf geführt und mehrfach in den Träger eingespeist. Verbrauchtes Reaktionsgas wird aus dem Kreislauf entfernt und durch frisches Reaktionsgas ersetzt.

Das Reaktionsgas kann, bevor es in den Träger eingespeist wird, zumindest in etwa auf die Sintertemperatur erwärmt werden. Bevorzugt hat das Gas dann eine Temperatur etwas über der Sintertemperatur, so dass das Band auch durch das Reaktionsgas auf die Sintertemperatur erwärmt wird.

Es können mehrere Bänder parallel und vorzugsweise voneinander beabstandet durch den Ofen gezogen werden. Der Abstand zwischen den Bändern ist vorzugsweise so zu bemessen, dass sich über jedem Band je eine Wirbelzone bildet. So können mehrere Bänder gleichzeitig gesintert werden, wobei jedes Band ausreichend und gleichmäßig mit Reaktionsgas beströmt wird.

Bevorzugt wird der Träger zumindest in dem der Eintrittsseite des Bandes in den Ofen zugewandten Bereich beheizt.

Dadurch kann das Band schnell auf die Sintertemperatur erwärmt werden.

Der Volumenstrom oder der Druck des in den Träger eingespeisten Gases kann so eingestellt werden, dass auch zwischen Band und Träger Reaktionsgas aus dem Träger austritt. Dadurch wird die Reibung zwischen dem Träger und dem Band reduziert. Dann lässt sich das Band leichter über den Träger ziehen und es entsteht weniger Abrieb. Feiner Abrieb würde mit im Kreislauf strömendem Gas in den Träger eingespeist und dessen Poren zumindest auf lange Sicht verstopfen.

Besonders bevorzugt wird das Reaktionsgas über dem Band bzw. den Bändern abgesaugt. Dadurch ist die Wirbelzone im Querschnitt etwa zwiebelförmig. Durch die Position und die Form der Abzugsöffnungen können die Größe der Wirbelzone, die Strömungsverhältnisse in der Wirbelzone und der Gasaustausch zwischen der Wirbelzone und der laminaren Strömung eingestellt werden.

Durch in zur Durchzugsrichtung parallel angeordnete Abzugsöffnungen erhält man in der Wirbelzone eine in Durchzugsrichtung weitgehend konstante mittlere Konzentration von frischem Reaktionsgas.

Besonders gut lässt sich die Strömung des Reaktionsgases kontrollieren, wenn die Abzugsöffnungen sich parallel zur Durchzugsrichtung erstreckende Schlitze sind und/oder wenn für jedes durch den Ofen gezogene Band eine eigene Reihe parallel zur Durchzugsöffnung angeordneter Abzugsöffnungen vorgesehen ist.

Zur Durchführung des zuvor beschriebenen Verfahrens ist ein Sinterofen geeignet, der einen porösen Träger als Auflage für ein Band mit einer HTSL-Precursorschicht, mindestens einen Einlass und mindestens einen Auslass für ein Reak-tionsgas hat. Der Träger kommuniziert mit dem Einlass für das Reaktionsgas. Dadurch kann Reaktionsgas - beispielsweise seitlich oder von unten - in den Träger einströmen und das Band wie zuvor beschrieben umströmen.

Bevorzugt hat der Ofen über dem Träger mindestens eine sich parallel zur Banddurchzugsrichtung erstreckende Absaugung zum Abführen von Reaktionsgas.

Anhand der Zeichnung wird die Erfindung näher erläutert. Es zeigen:
- Fig. 1: eine stark vereinfachte, schematische Darstellung eines erfindungsgemäßen Ofens,
- Fig. 2: den Strömungsverlauf in dem Ofen nach Fig. 1 mit abgesenktem Träger,
- Fig. 3: den Strömungsverlauf in dem Ofen nach Fig. 1 mit Träger in Mittelstellung und
- Fig. 4: den Strömungsverlauf in dem Ofen nach Fig. 1 mit angehobenem Träger.

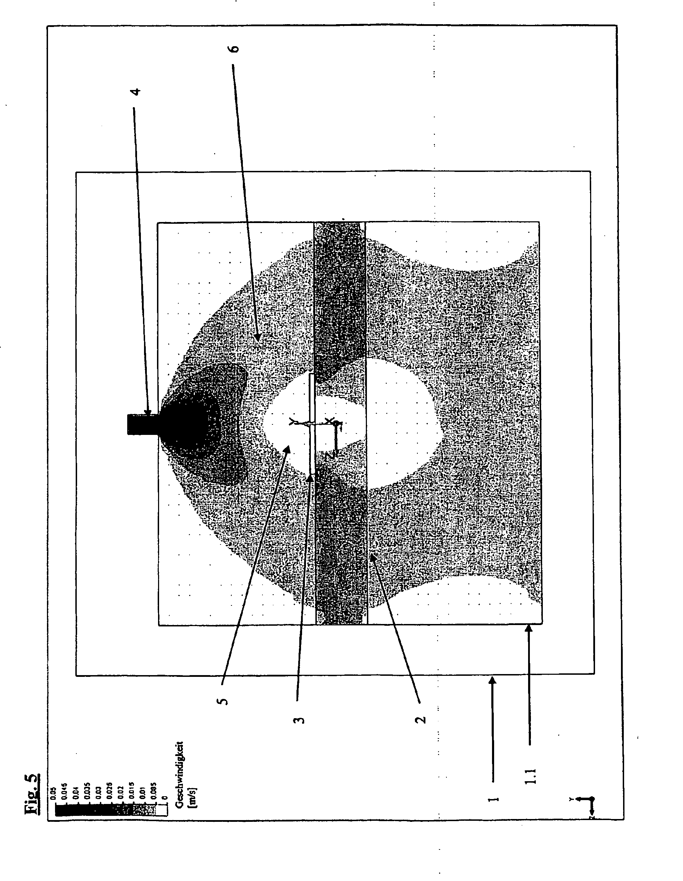

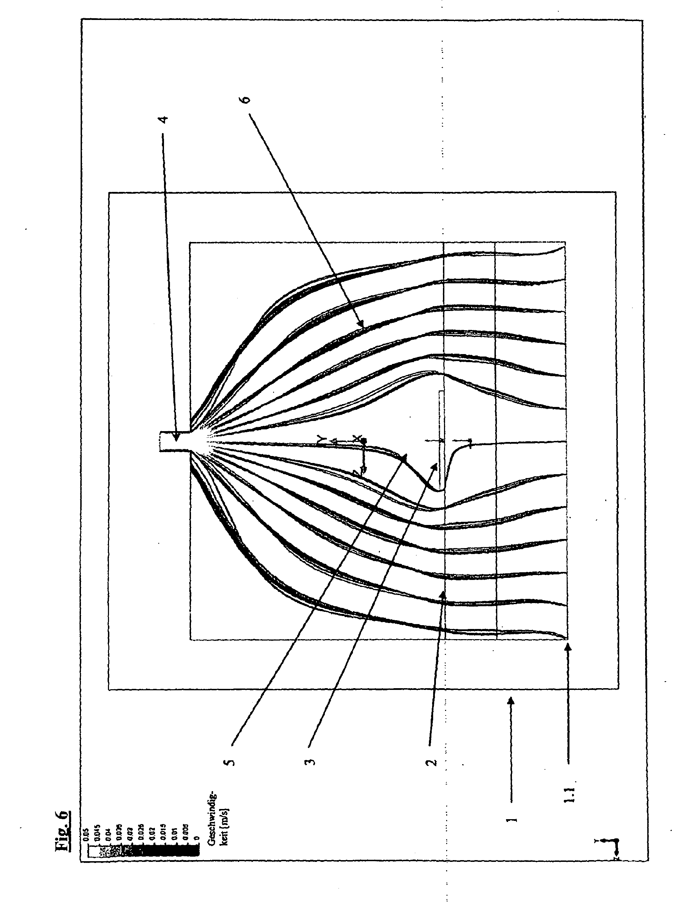

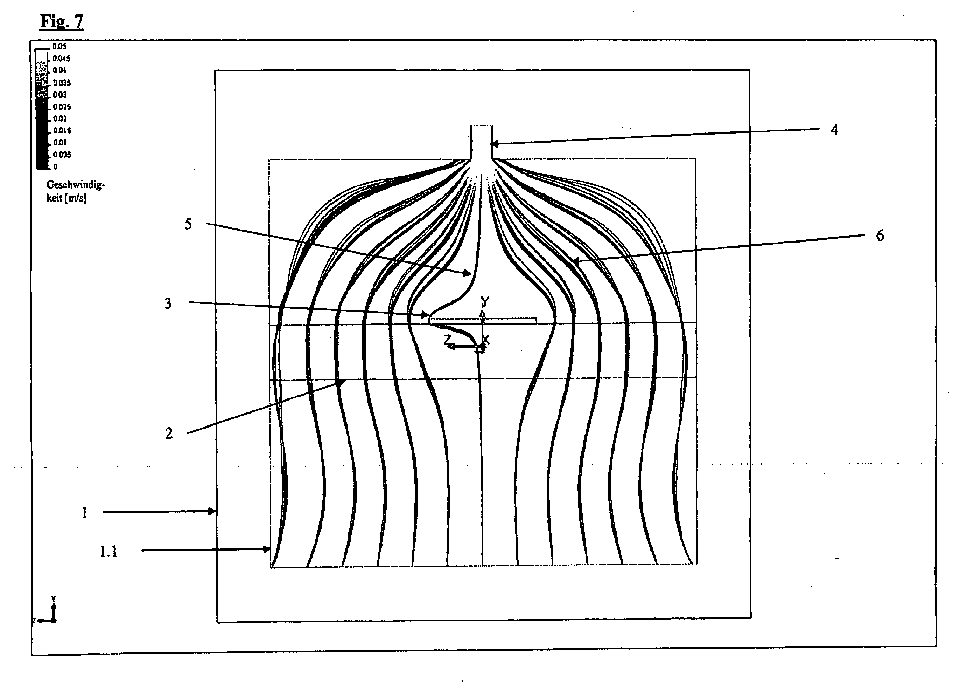

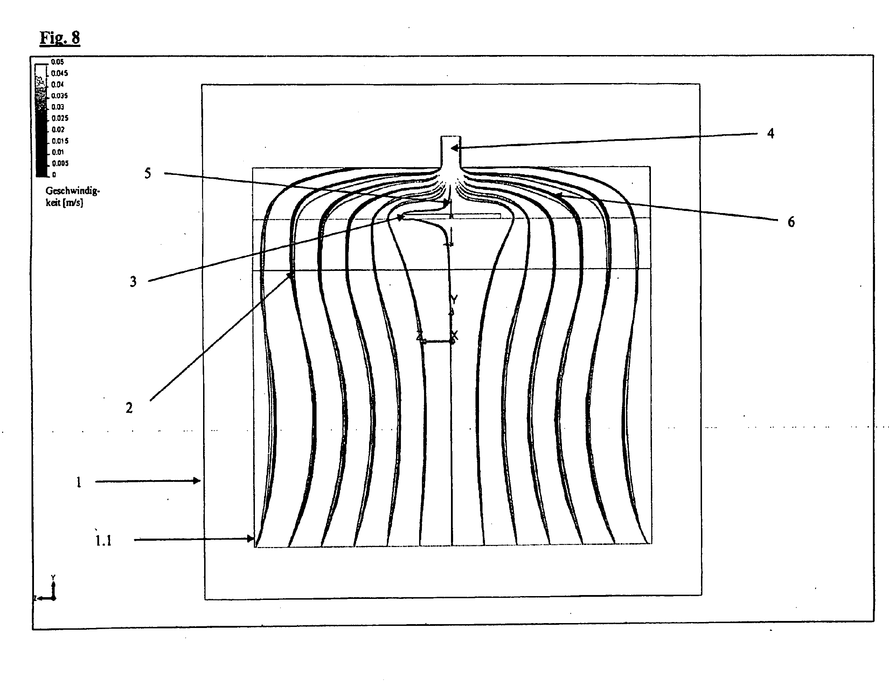

- Fig. 5 bis 8: die Konfigurationen der Fig. 1 bis 4, jedoch mit farbkodierten Strömungsgeschwindigkeiten.

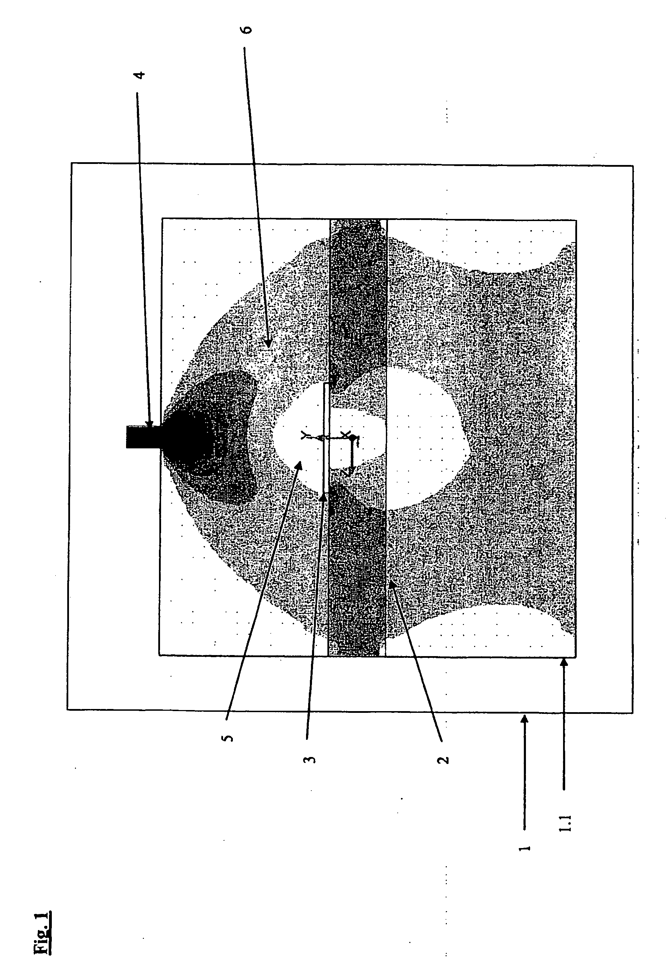

Der in Fig. 1 im Querschnitt gezeigte Ofen 1 hat einen durch eine Ofeninnenwand 1.1 begrenzten Ofenraum. In dem Ofenraum ist ein heb- und senkbarer Träger 2 aus einer porösen Platte. Die poröse Platte schließt beidseitig mit der Ofeninnenwand 1.1 ab. Auf dem Träger 2 befindet sich ein Band 3, das auf seiner Oberseite eine Precursorschicht hat. Das Band 3 wird orthogonal zur Schnittebene über den Träger 2 gezogen. Über dem Band 3 ist in der Ofeninnenwand 1.1 eine Abzugsöffnung 4.

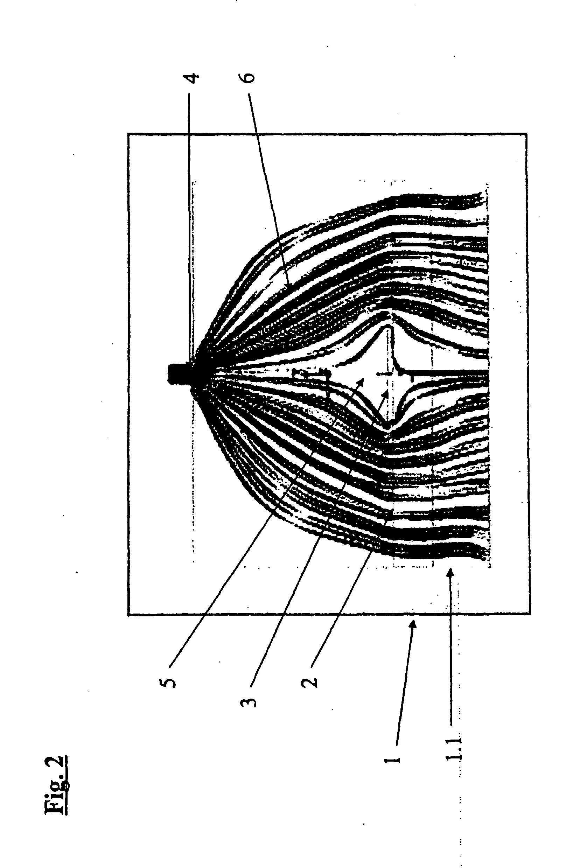

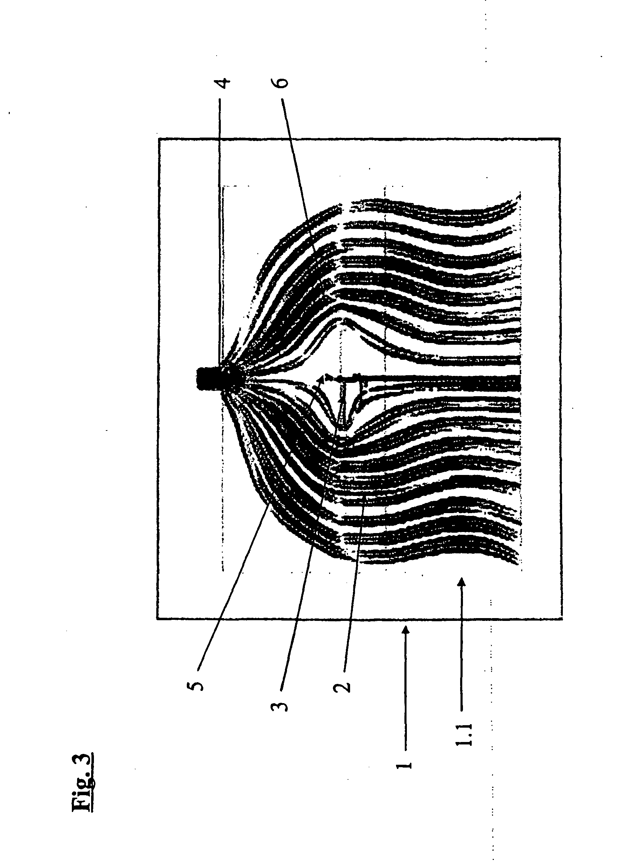

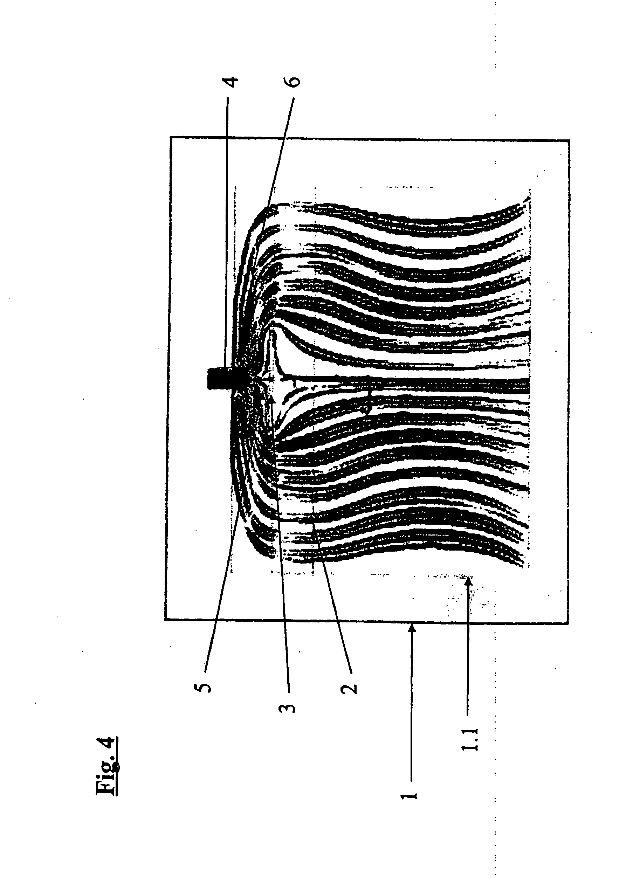

Wird unterhalb des Trägers 2 Reaktionsgas in den Ofen 1 gespeist, so bildet sich über dem Träger 2 neben dem Band 3 eine weitgehend laminare Strömung 6 zur Abzugsöffung 4 (vgl. Fig. 2 bis Fig. 4). Über dem Band bildet sich in dessen Strömungsschatten eine im Querschnitt etwa zwiebelförmige Wirbelzone 5. Durch Heben und Senken des Trägers 2 kann der Abstand zwischen dem Band 3 und der Abzugsöffnung 4 variiert werden. Dadurch lässt sich bei konstantem Volumenstrom des Reaktionsgases die Größe und Form der Wirbelzone und damit die Strömungsgeschwindigkeit in der Nähe der Precursorschicht sowie der Grad des Gasaustausches zwischen der Wirbelzone 5 und dem Bereich laminarer Strömung 6 einstellen.

## Patentansprüche

1. Verfahren zum Herstellen eines Hochtemperatur-Supraleiters (HTSL) aus einem Band (3) mit einer oberseitigen HTSL-Precursorschicht, das zum kontinuierlichen Sintern letzterer in einem Ofen (1) in Anwesenheit eines eingespeisten Reaktionsgases über einen Träger (2) gezogen wird, **dadurch gekennzeichnet, dass** durch Einspeisen des Reaktionsgases von unten in den porös ausgebildete Träger (2) über der Precursorschicht eine Wirbelzone (5) erzeugt wird.

2. Verfahren nach Anspruch 1, **dadurch gekennzeichnet, dass** zumindest ein Teil des Reaktionsgases mehrfach in den Träger (2) eingespeist und der übrige Teil durch frisches Gas ersetzt wird.

3. Verfahren nach Anspruch 1 oder 2, **dadurch gekennzeichnet, dass** das Reaktionsgas erwärmt wird.

4. Verfahren nach einem der Ansprüche 1 bis 3, **dadurch gekennzeichnet, dass** mindestens ein weiteres Band parallel zum ersten Band und von diesem beabstandet durch den Ofen (1) gezogen wird.

5. Verfahren nach einem der Ansprüche 1 bis 4, **dadurch gekennzeichnet, dass** der Träger (2) zumindest in dem der Eintrittsseite des Bandes (3) zugewandten Bereich beheizt wird.

6. Verfahren nach einem der Ansprüche 1 bis 5, **dadurch gekennzeichnet, dass** der Volumenstrom des eingespeisten Reaktionsgases so eingestellt wird, daß die Reibung zwischen dem Träger (2) und dem Band (3) durch zwischen dem Träger (2) und dem Band (3) austretendes Reaktionsgas reduziert wird.

7. Verfahren nach einem der Ansprüche 1 bis 6, **dadurch gekennzeichnet, dass** das Reaktionsgas über dem Träger (2) abgesaugt wird.

8. Verfahren nach Anspruch 7, **dadurch gekennzeichnet, dass** das Reaktionsgas über in wenigstens einer zur Durchzugsrichtung parallelen Reihe angeordnete Abzugsöffnungen (4) abgesaugt wird.

9. Verfahren nach Anspruch 8, **dadurch gekennzeichnet, dass** jedem Band (3) wenigstens eine Reihe von Abzugsöffnungen (4) zugeordnet wird.

10. Sinterofen (1) mit einem Träger (2) als Auflage für ein Band (3) mit einer HTSL-Precursorschicht und mit mindestens einem Einlass und mindestens einem Auslass (4) für ein Reaktionsgas, **dadurch gekennzeichnet, dass** der Träger (2) porös ist und der Einlass für das Reaktionsgas mit dem Träger (2) kommuniziert, so dass das Reaktionsgas von unten in den Träger eingespeist werden kann.

11. Sinterofen nach Anspruch 10, **gekennzeichnet durch** mindestens eine sich parallel zur Banddurchzugsrichtung erstreckende Absaugung (4) über dem Träger (2) zum Abführen von Reaktionsgas.

## Claims

1. A method for producing a high-temperature superconductor (HTSC) from a tape (3) with an HTSC precursor layer on the upper side which is drawn over a carrier (2) in the presence of a fed reaction gas for the continuous sintering of said layer in a furnace (1), **characterized in that** an eddy zone (5) is produced above the precursor layer by feeding the reaction gas from below into the porously arranged carrier (2).

2. A method according to claim 1, **characterized in that** at least a portion of the reaction gas is fed several times into the carrier (2) and the remaining portion is replaced by fresh gas.

3. A method according to claim 1 or 2, **characterized in that** the reaction gas is heated.

4. A method according to one of the claims 1 to 3, **characterized in that** at least one further tape is drawn through the furnace (1) parallel to the first tape and spaced from the same.

5. A method according to one of the claims 1 to 4, **characterized in that** the carrier (2) is heated at least in the region facing the entrance side of the tape (3).

6. A method according to one of the claims 1 to 5, **characterized in that** the volume flow of the fed reaction gas is set in such a way that the friction between the carrier (2) and the tape (3) is reduced by reaction gas escaping between the carrier (2) and the tape (2).

7. A method according to one of the claims 1 to 6, **characterized in that** the reaction gas is sucked off above the carrier (2).

8. A method according to claim 7, **characterized in that** the reaction gas is sucked off through fume discharge openings (4) arranged in at least one row parallel to the direction of passage.

9. A method according to claim 8, **characterized in that** each tape (3) is associated with at least one row of fume discharge openings (4).

10. A sintering furnace (1), comprising a carrier (2) as a support for a tape (3) with an HTSC precursor layer and at least one inlet and at least one outlet (4) for a reaction gas, **characterized in that** the carrier (2) is porous and the inlet for the reaction gas communicates with the carrier (2), so that the reaction gas can be fed from below into the carrier.

11. A sintering furnace according to claim 10, **characterized by** at least one suction system (4) above the carrier (2) for removing reaction gas, which suction system extends parallel to the direction of passage of the tape.

## Revendications

1. Procédé de fabrication d'un supraconducteur à haute température (SCHT) à partir d'une bande (3) portant sur sa face supérieure une couche de précurseur de SCHT, qui est tirée dans un four (1) en vue de son frittage en continu par-dessus un support (2) en présence d'un gaz de réaction amené, **caractérisé en ce que** pour amener le gaz de réaction par en dessous dans le support conçu pour être poreux (2), une zone de turbulences (5) est créée par-dessus la couche de précurseur.

2. Procédé selon la revendication 1, **caractérisé en ce qu'**une partie au moins du gaz de réaction est amené plusieurs fois dans le support (2) et le reste est remplacé par du gaz neuf.

3. Procédé selon la revendication 1 ou 2, **caractérisé en ce que** le gaz de réaction est chauffé.

4. Procédé selon l'une des revendications 1 à 3, **caractérisé en ce qu'**au moins une autre bande est tirée à travers le four (1) parallèlement à la première bande et à distance de celle-ci.

5. Procédé selon l'une des revendications 1 à 4, **caractérisé en ce que** le support (2) est chauffé au moins dans la partie orientée vers le côté d'entrée de la bande (3).

6. Procédé selon l'une des revendications 1 à 5, **caractérisé en ce que** le débit volumétrique du gaz de réaction amené est réglé de telle façon que le frottement entre le support (2) et la bande (3) est réduit par du gaz de réaction sortant entre le support (2) et la bande (3).

7. Procédé selon l'une des revendications 1 à 6, **caractérisé en ce que** le gaz de réaction est aspiré en passant par le support (2).

8. Procédé selon la revendication 7, **caractérisé en ce que** le gaz de réaction est aspiré en passant par au moins une ouverture d'extraction (4) disposée dans une rangée parallèle à la direction d'entraînement.

9. Procédé selon la revendication 8, **caractérisé en ce que** chaque bande (3) est associée à au moins une rangée d'ouvertures d'extraction (4).

10. Four de frittage (1) avec un support (2) servant d'appui pour une bande (3) portant une couche de précurseur de SCHT et avec au moins une entrée et au moins une sortie (4) pour une gaz de réaction, **caractérisé en ce que** le support (2) est poreux et l'entrée pour le gaz de réaction communique avec le support (2), de sorte que le gaz de réaction peut être amené dans le support par dessous.

11. Four de frittage selon la revendication 10, **caractérisé en ce qu'**il comprend au moins une aspiration (4) s'étendant parallèlement au sens d'entraînement de la bande au-dessus du support (2) pour évacuer le gaz de réaction.
